(19) Europäisches Patentamt
European Patent Office
Office européen des brevets

(11) **EP 3 349 311 A1**

(12) **EUROPEAN PATENT APPLICATION**
published in accordance with Art. 153(4) EPC

(43) Date of publication:
**18.07.2018 Bulletin 2018/29**

(51) Int Cl.:
*H01R 24/76* (2011.01)    *H01R 13/46* (2006.01)
*H01R 13/66* (2006.01)    *H01R 13/703* (2006.01)
*H01R 103/00* (2006.01)   *H02J 3/14* (2006.01)
*H02J 13/00* (2006.01)

(21) Application number: **16844673.0**

(22) Date of filing: **07.09.2016**

(86) International application number:
**PCT/KR2016/010010**

(87) International publication number:
**WO 2017/043855 (16.03.2017 Gazette 2017/11)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **09.09.2015 KR 20150127469**

(71) Applicant: **Kim, Soon**
**Guro-gu, Seoul 08336 (KR)**

(72) Inventor: **Kim, Soon**
**Guro-gu, Seoul 08336 (KR)**

(74) Representative: **Zardi, Marco**
**M. Zardi & Co. SA**
**Via Pioda 6**
**6900 Lugano (CH)**

(54) **ELECTRICAL DEVICE MANAGEMENT SYSTEM**

(57)    The present disclosure relates to a system for managing electrical devices that are used to connect to power breaker devices (no fuse breaker (NFB), earth leakage breaker (ELB), vacuum circuit breaker (VCB), air circuit breaker (ACB), magnetic switch (MG-SW), etc.) or electrical wiring devices (socket, plug, multi-tap outlet, etc.) for supplying and blocking power for each electrical and electronic device in apartments, buildings, factories or large vessels. The system includes a power supply unit, a recognition number generator for generating a recognition number for the electrical or electronic devices depending on the power provided by the power supply unit; a sorting means for sorting the degree of connections of the electrical or electronic devices according to the generated recognition number generated by the recognition number generator, and a determination means. As a result, electrical devices can efficiently be managed and various electricity related safety accidents can be prevented.

FIG. 5

EP 3 349 311 A1

**Description**

Technical Field

The present disclosure relates to a system for managing electrical devices used in general houses, an apartment complex or buildings, factories, large vessels, airplanes, etc. More particularly, the present disclosure relates to a system for managing electric devices, electronic devices, home appliances, etc. used by being connected to a power disconnecting device (no fuse breaker (NFB), earth leakage breaker (ELB), vacuum circuit breaker (VCB), air circuit breaker (ACB), magnetic switch (MG-SW) and the like) and to an electrical wiring device (socket, plug, multi-tap outlet and the like), wherein the power disconnecting device and the electrical wiring device are used for supplying and blocking power for various electrical devices, electronic devices, and home appliances in each stage of generation (production), transmission and distribution (transportation), and use (consumption) of electric power.

Background Art

A general electrical outlet activates an electrical device immediately by supplying power when the electrical device is connected thereto. In this case, electrical energy used by the electrical device cannot be managed since it is not known what type and how much electrical energy the electrical device uses.

An electrical device management system is a method of managing a status of electricity use of an electrical device by matching an electrical device and an electrical outlet by assigning a network function to the electrical outlet and allowing recognition information on the electrical device connected to the electrical outlet to be automatically registered to the electrical device management system by the electrical device itself. This method has an advantage to monitor and manage a status of electrical energy use of the electrical device through a user interface of the electrical device management system. However, even though this method is useful for an electrical energy management of the electrical device steadily connected to the designated electrical outlet, there is a drawback of frequent occurrence of user's involvement for the electrical device using a plug configured to be used with different electrical outlets frequently, because the user should adjust a change of outlets by a user interface whenever the user wants to select one of the outlets.

In addition, the number of devices which use electricity has rapidly increased thanks to a development of information and telecommunication technology, whereby an electricity demand is increasing year by year. Recently, studies have been increased on demand response (DR) which is an advanced type of demand management. Here, the DR is how a user uses electricity in response to electric charges getting away from a routine electricity consumption pattern, whereby demand and supply of electricity is to be balanced.

That is, an electricity supplier can induce users to use electricity in a timeslot when power consumption is low whereby an electricity charge is cheap and restrain users from using electricity in a timeslot when power consumption is high whereby electricity charge is expensive, and, likewise, a user can use electricity with low electricity charge.

Accordingly, an electric power manager (also called as an Energy Management System) being applied the DR has been developed and this electric power manager indicates electric power cost through a display by being transmitted electric power cost information from the electric power supplier. In addition, the electric power manager performs communication with various electrical devices and controls operation of each electrical device based on electric power cost. The electrical device here means a smart electrical device that is able to perform electric power measurement and communication.

Meanwhile, for communication between the electric power manager and the smart electrical device, a user or manager should manually register the smart electrical device on the electric power manager. At this point of time, the user or manager should manually input a unique ID and an IP address of the smart electrical device and an IP address of a gateway into the electric power manager, the IP address of the smart electrical device and the IP address of the gateway into the smart electrical device, and the ID of the smart electrical device into the gateway. In addition, when the smart electrical device is replaced or removed, the user or manager should manually delete the ID, the IP address and so on of the relevant smart electrical device registered on the electric power manager.

Like this, since the user or manager should manually input the ID, the IP address and so on of the smart electrical device one by one when the electrical device is registered or reregistered on, or modified or removed from the electric power manager, there is a problem that the process is complicated and difficult.

An example of technology to resolve such a problem is disclosed in the following references such as 1, 2 and the like.

For example, in Korean Patent No. KR 2012-0097105 (published on 23.09.2012), disclosed is an electrical device which includes:

a communication unit performing communication with at least one of a plurality of different electrical devices and a gateway; and

a control unit broadcasting a signal requesting a gateway search, performing communication with the gateway based on a response signal to the gateway search when the response signal to the gateway search is transmitted from at least one of a plurality of different electrical devices and the gateway, and

requesting registering on the electric power manager through the gateway.

In addition, in Korean Patent No. KR 2013-0071165 (published on 28.06.2013), as illustrated in FIG. 1, disclosed is an electrical outlet device 110 which includes:

An electric power measurement unit 111;

an RFID (radio frequency identification) reader 112;

a control unit 113 managing received information on the electrical device and information on measured electric power energy; and a communication unit 114 transmitting the information on the electrical device and information on the electric power energy to the electric power manager, and measures:
an electric power energy consumed in a relevant electrical device in such a way that

a plug 120 of the electrical device attached with an RFID tag is connected through a plug connection part formed in the electrical outlet device 110 and

the electric power measurement unit 111 is connected to the power source being supplied to the plug 120 of the electrical device attached with the RFID tag through the plug connection part.

Disclosure

Technical Problem

However, in the conventional technique as described above, power used in each electrical device could be only individually checked or transmitted, but power consumption by management objects such as general houses, an apartment complex or buildings, factories, large vessels, airplanes, etc., or by regions could not be managed through communicating with each other at each device by systematizing like an electrical one line diagram based on communication between electrical devices.
In addition, in the above described conventional technique, when an Internet of Things is applied, the object to be applied was operable only when it was kept in a state ON, whereby a problem of power dissipation occurred. In addition, when power is blocked (OFF) from a power supply unit, power could not be supplied (ON) to a relevant device only by the Internet of Things.
An objective of the present disclosure contrived to resolve problems described above is to secure an electrical schematic diagram of an apartment complex or buildings, factories, large vessels and the like, thereby to provide an electrical device management system to efficiently implement an electrical device management.
Another objective of the present disclosure is, in the case that an Internet of Things is applied, to provide an electrical device management system which can not only implement safe use (ON/OFF) but also prevent power dissipation by blocking standby power.

Technical Solution

An electrical device management system according to the present disclosure to accomplish above objectives includes: a power supply unit supplying and blocking power to a plurality of electrical or electronic devices; a recognition number generator generating recognition numbers of the plurality of electrical or electronic devices depending on the power supplied from the power supply unit; a sorting means sorting a degree of connections of the plurality of electrical or electronic devices in accordance with the recognition numbers generated by the recognition number generator; and a determination means determining information on the plurality of electrical or electronic devices in accordance with the degree of connections sorted by the sorting means. 17
The recognition number generator of the electrical device management system according to the present disclosure generates a manufacturer's unique number of an electrical or electronic device, an installation position number, a manager's management number, a user's password, and a recognition number of any one of transmission and distribution systems.
The determination means of the electrical device management system according to the present disclosure determines information on electrical or electronic devices by supplying or blocking the power to the electrical or electronic devices from the power supply unit.

The recognition number of the electrical device management system according to the present disclosure is assigned to each one of a breaker or a switch, a circuit breaker or an earth leakage breaker, a magnetic switch, or an outlet and a plug of an electrical system of generation and transformation, transmission and distribution, and a distribution board as well as an electrical device and a home appliance.

The determination means of the electrical device management system according to the present disclosure determines the number of the electrical or electronic devices, to which power is supplied from the power supply unit, by supplying or blocking power to the electrical or electronic devices from the power supply unit.

An electrical device according to the present disclosure includes: a power supply unit supplying and blocking power to the electrical or electronic devices; a recognition number generator generating recognition numbers of the electrical or electronic devices depending on the power supplied from the power supply unit; a sorting means sorting a degree of connections of the electrical or electronic devices in accordance with the recognition numbers generated by the recognition number generator; and a determination means determining information on the electrical or electronic devices in accordance with the degree of connections sorted by the sorting means, and controls ON or OFF of the electrical or electronic devices in accordance with the recognition numbers.

Advantageous Effects

As described above, according to the electrical device management system according to the present disclosure, it is possible to realize effective electrical device management which is a basis of electrical safety. Consequentially, various electrical accidents can be prevented in advance by recognizing symptoms thereof and unnecessary standby power can be almost perfectly blocked since devices of an Internet of Things which are turned OFF can be turned ON by confirming a system and a degree of connections.

According to the electrical device management system according to the present disclosure, electrical bills, when mixed by industrial classification, for various purposes of residence, business, industry and so on can be easily managed, power management can be efficiently implemented since big data for electricity use can be secured, and a cause of an electrical accident can be disclosed as the system plays even a role as a black box.

According to the electrical device management system according to the present disclosure, there are effects to be capable of managing by harmonizing electrical one line diagrams for a prevention of an illegal electricity use and the electrical device management.

In addition, according to the electrical device management system according to the present disclosure, there is an effect to prevent an electricity related safety accident in advance since the electrical system can recognize and block a short circuit, an electric shock, an overload state, and an electrical fire and so on.

In addition, according to the electrical device management system according to the present disclosure, by efficiently blocking a standby power, new construction of a 1,000,000-1,500,0000 kW nuclear power plant may become unnecessary. In addition, the system can prevent losses of both life and property since it can prevent various accidents which might occur due to accidental changes in situation in any stage of generation (production), transmission and distribution (transportation), and use (consumption) of electric power.

Particularly, due to characteristics of electricity that generation (production) and use (consumption) of electric power are performed simultaneously, a safety device (buffer) for the production and the consumption of electric power may be realized when an automatic electrical device management system is adopted.

Description of Drawings

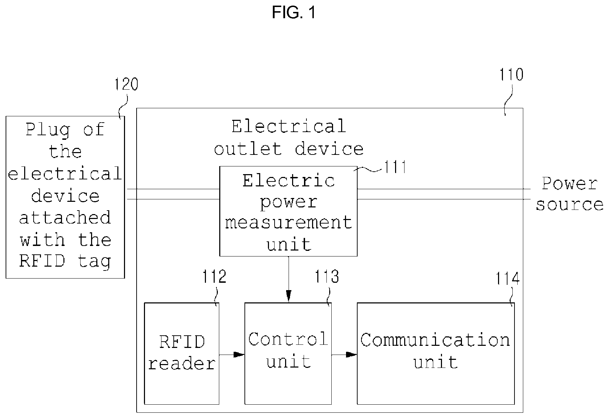

FIG. 1 is a block diagram illustrating a power outlet device sensing electrical devices automatically according to a related art.

FIG. 2 is a block diagram illustrating the configuration of an electrical device management system according to the present disclosure.

FIG. 3 is a circuit diagram illustrating the configuration of a breaker used in the electrical device management system according to the present disclosure.

FIG. 4 is a circuit diagram of an outlet used in the electrical device management system according to the present disclosure.

FIG. 5 is a flow diagram illustrating a process for sorting a degree of connections of electrical devices automatically in an apartment complex according to the present disclosure.

FIG. 6 is a flow diagram illustrating a process for sorting a degree of connections of electrical devices automatically with respect to a multi tap connected to an outlet 20 according to the present disclosure illustrated in FIG. 5.

FIG. 7 is a flow diagram illustrating a process for sorting a degree of connections of electrical devices automatically with respect to a multi tap provided with switches and connected to a conventional outlet 20' illustrated in FIG. 5.

Best Mode

The above and other objectives, and new characteristics of the present disclosure will be more clearly understood from the following detailed description when taken in conjunction with the accompanying drawings.

The electrical device management system according to the present disclosure is for all devices that generates, transmits or distributes, or uses electricity and is able to automatically sort a degree of connections of electrical devices including electric meter. In the case that electrical or electronic devices have discernible recognition numbers (product serial numbers), the electrical device management system can automatically sort the degree of connections of electrical devices by using wired and wireless communications (including Internet of Things).

That is, in the present disclosure, electrical devices and electrical appliances involved in the process of generation (production), transmission and distribution (transportation), and use (consumption) of electric power are attached with electronic circuits for power analysis and wired and wireless communication circuits. In addition, recognition numbers are assigned automatically to all electrical devices and electrical appliances. Thereafter, the automatically assigned recognition numbers are systematized by sorting the degree of connections in consecutive order and a status of electricity usage of systematized electrical devices is compared and analyzed, whereby electricity can be safely used and efficiently saved and managed.

In addition, the electrical devices used in the present disclosure mean a generator, a transformer, power disconnecting devices such as a circuit breaker (NFB), an earth leakage breaker (ELB), a vacuum breaker (VCB), an air breaker (ACB), a magnet switch (MG-SW), and so on, or electrical wiring devices such as an outlet, a plug , a multi tap, and so on, a motor, a pump, and so on, and home appliances include a TV, a PC, a refrigerator, an air conditioner, a copy machine, a facsimile, a microwave oven, a coffee machine, and so on, used in a home or an office.

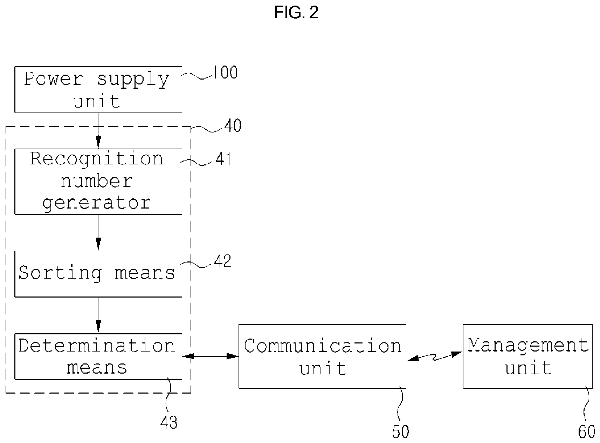

Hereinafter, the electrical device management system according to the present disclosure will be described with reference to FIG. 2.

FIG. 2 is a block diagram illustrating the configuration of an electrical device management system according to the present disclosure.

The electrical device management system according to the present disclosure as illustrated in FIG. 2 includes a power supply unit 100 supplying and blocking power to electrical or electronic devices, a control unit 40 consisting of a microprocessor unit (MPU) equipped with a microprocessor and a memory, sensing power used in electrical devices or home appliances along the power supplied from the power supply unit 100, and sorting degrees of connections of electrical devices or home appliances, and a communication unit 50 transmitting information on electrical devices or home appliances determined by the control unit 40 to a management unit 60. In the case that communication unit 50 and management unit 60 are located far from each other, a repeater relaying transmission and reception of the information may be included.

The communication unit 50 may be preferably equipped with function of radio communications by, for example, Bluetooth, Wi-Fi, RFID, and so on and a wire communication by power line communication (PLC). Meanwhile, the communication unit 50 can transmit information to and receive information from another higher or lower level communication unit 50 connected to a distribution system or the management unit 60. In addition, the communication unit 50 can transmit measured data by a repeater installed considering a distance.

The management unit 60 responds to a computer system provided in, for example, a superintendent's office in case of an apartment, a power control room in case of a factory, a central steering house in case of a vessel. Alternatively, a smart phone, a pad, a PDA, or a notebook of a user, for which an electrical device management application according to the present disclosure is operable, may be also applied.

The power supply unit 100 means a power system that can supply and block power to electrical or electronic devices including a generator, a transformer, power disconnecting devices such as a circuit breaker (NFB), an earth leakage breaker (ELB), a vacuum breaker (VCB), an air breaker (ACB), a magnet switch (MG-SW) and so on, electrical wiring devices such as an outlet, a plug, a multi tap, and so on.

The control unit 40 consisted of an MPU and a memory can be made up of a chip, and built in a PCB of the power supply unit 100.

In addition, the control unit 40 includes a recognition number generator 41 generating recognition numbers of a plurality of electrical or electronic devices depending on the power supplied from the power supply unit 100, a sorting means 42 sorting the degree of connections of electrical or electronic devices in accordance with a plurality of recognition numbers generated in the recognition number generator 41, and a determination means 43 determining information on a plurality of electrical or electronic devices in accordance with the degree of connections sorted by the sorting means 42.

The recognition number generator 41 generates a manufacturer's unique number which is a serial number of the electrical and electronic device, an installation position number according to an address and a distribution system etc., a manager's management number for electricity bill and safety management, etc., a user's password according to ON/OFF and administration of use of electrical or electronic devices, and a recognition number, automatically generated and modifiable at a breaker, of any one of transmission and distribution systems.

The recognition number generated in the recognition number generator 41 is assigned to electrical devices that can embed the recognition number and the electrical devices include all devices that generate, transmit and distribute, and use electricity, and electric meters. For example, the recognition number is assigned to each one of a breaker or a switch of generation and transformation, transmission and distribution, and a distribution board, a circuit breaker or an ELB, a MG-SW, an outlet including a multi tap and a plug, electrical devices such as a motor, a heater, a pump, and so on, and home appliances such as a TV, a PC, a refrigerator, an air conditioner, and so on.

The determination means 43 determines information on electrical or electronic devices connected to the power supply unit 100 by supplying or blocking power to the electrical or electronic devices from the power supply unit 100. Such information includes a recognition number generated in the recognition number generator 41.

In addition, the determination means 43 can determine the number of the electrical or electronic devices supplied from the power supply unit 100 by supplying or blocking power to the electrical or electronic devices from the power supply unit 100.

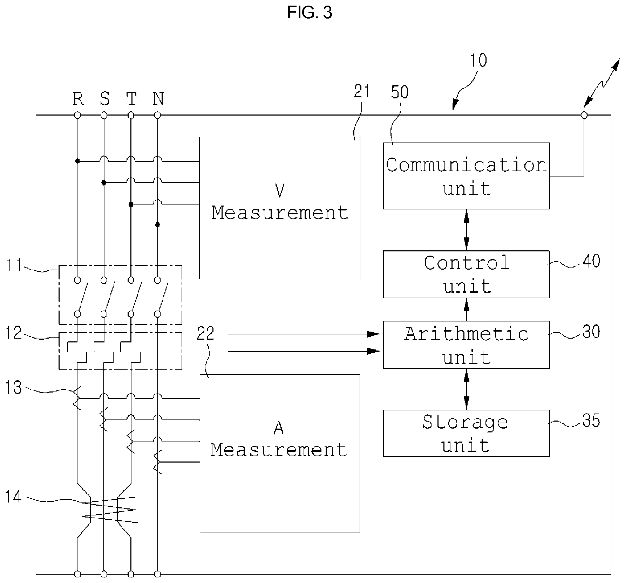

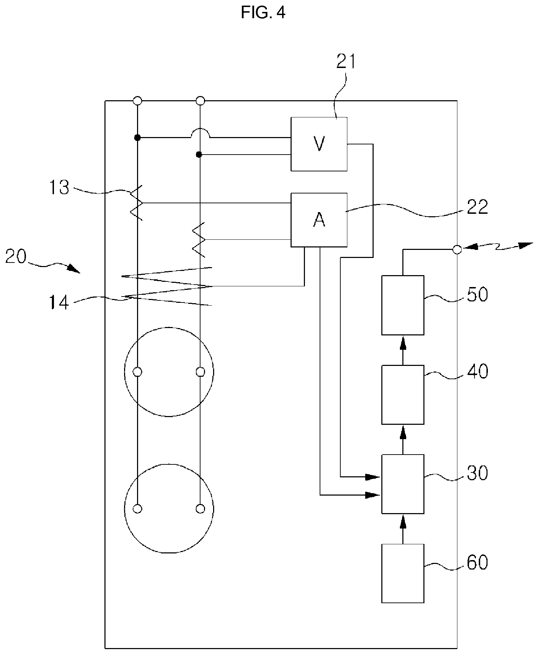

Hereinafter, a breaker 10 and an outlet 20 of the electrical device management system applied to the present disclosure will be described in detail with reference to FIGS. 3 and 4.

FIG. 3 is a circuit diagram illustrating the configuration of a breaker 10 used in the electrical device management system according to the present disclosure and FIG. 4 is a circuit diagram of the outlet 20 used in the electrical device management system according to the present disclosure.

In FIG. 3, the power supply unit 100 is composed of the breaker 10 and may be equipped with: a set of manual levers 11 provided between terminals R, S, T, and N on the supply line side supplied from external power lines and terminals U, V, W, and N on the load side of electrical devices and so on, respectively; a set of bimetal thermostats 12, each connected to each of the manual levers except a neutral line (terminal N); a set of current transformer (CT) 13, provided between the terminals R, S, T, and N on the supply line side and the terminals U, V, W, and N on the load side, respectively, to measure a current of each phase; and a zero phase current transformer (ZCT) 14 to measure a current between the supply line side of terminals R, S, and T and the load side of terminals U, V, and W.

Meanwhile, the power supply unit 100 in FIG. 4 is composed of the outlet 20 and equipped with a set of CT 13 to measure a current of each single phase; and a ZCT 14 to measure a current.

In addition, although it was described above that the voltage was measured by using a potential transformer (PT), it is not limited to this and the voltage may be measured by using an integrated circuit (IC) for voltage measurement. In addition, although it was expressed that current value was measured by using composition of CTs, it is not limited to this and a composition of a hall sensor or a current sensor would be well applied.

The measurement of a voltage and a current according to the present disclosure is performed by: a voltage measurement unit 21 which is equipped with the PT to measure each of the line voltage and includes an analog-digital converter converting the measured value to a digital value; and a current measurement unit 22 which is equipped with an analog-digital converter converting the analog value measured by the CT 13 to a digital value as described above.

As described above, each measurement value measured in the voltage measurement unit 21 and the current measurement unit 22, respectively, is stored in a storage unit 35 through an arithmetic unit 30. Alternatively, a structure may well be provided to directly store each measurement value measured in the voltage measurement unit 21 and the current measurement unit 22, respectively, to the storage unit 35.

The arithmetic unit 30 is implemented by the MPU described above. In addition, depending on various conditions of a power analysis stored in the storage unit 35 composed of a memory, the arithmetic unit 30 can perform various power analysis for the voltage value and the current value outputted from the voltage measurement unit 21 and the current measurement unit 22, respectively.

For example, in the arithmetic unit 30, a power factor can be obtained through a calculation of a time difference between occurrences of zero point of the voltage V value and the current A value, respectively, and a resistance $\Omega$ or impedance $Z \, \Omega$ can be found through dividing voltage V value by current A. This can be simply expressed in equations as follows.

$$Apparent\ power\ VA = V * A$$

$$Active\ power\ W = V * A * Cos\theta$$

$$Reactive\ power\ VAR = V * A * Sin\theta$$

As described above, the apparent power, the active power, and the reactive power can be obtained for loads of the electrical or electronic devices.

In addition, when each of the apparent power VA, the active power W, and the reactive power VAR are multiplied by time hour, respectively, an amount of apparent power VAh, an amount of active power Wh, and an amount of reactive power VARh can be obtained.

Besides, in the arithmetic unit 30, a frequency Hz, higher harmonics (nth), an inrush current A, a voltage between phase V, a phase current A, an unbalanced voltage V, an unbalanced current A, and so on can be calculated.

In addition, for a predetermined period of time, a maximum value, a minimum value, and a mean value of these measured and analyzed values can be calculated and the measured values calculated like this may be stored in the storage unit 35 or transmitted to the management unit 60 through the control unit 40 and the communication unit 50 by wired and wireless communications.

Meanwhile, the control unit 40 controls the communication unit 50 to transfer calculated values calculated by the arithmetic unit 30 or power analysis data and so on stored in the storage unit 35 to the management unit 60. In addition, the control unit 40 receives a signal of the management unit 60 through the communication unit 50, and can control supplying and blocking of power in the power supply unit 100, accordingly. In addition, the control unit 40 can control to block the power supply in the power supply unit 100 in the case that measurement value in the voltage measurement unit 21 or the current measurement unit 22 deviates a range of measured values set in the storage unit 35 due to an occurrence of a leakage current, a short circuit current or a shock current.

In addition, up to now, although the arithmetic unit 30, the control unit 40, the communication unit 50 and the storage unit 35 have been described as an individual element of the composition, it is not limited to this and these may well be integrated into a chip composed of the MPU above. By providing above composition into a single chip, it can be easily installed in the outlet 20 which has a relatively small size.

In addition, the communication unit 50 is configured for wired and wireless communications to be implemented, for example, between a breaker 10 and a breaker 10, or an outlet 20 and an outlet 20, wherein breakers or outlets are adjacent.

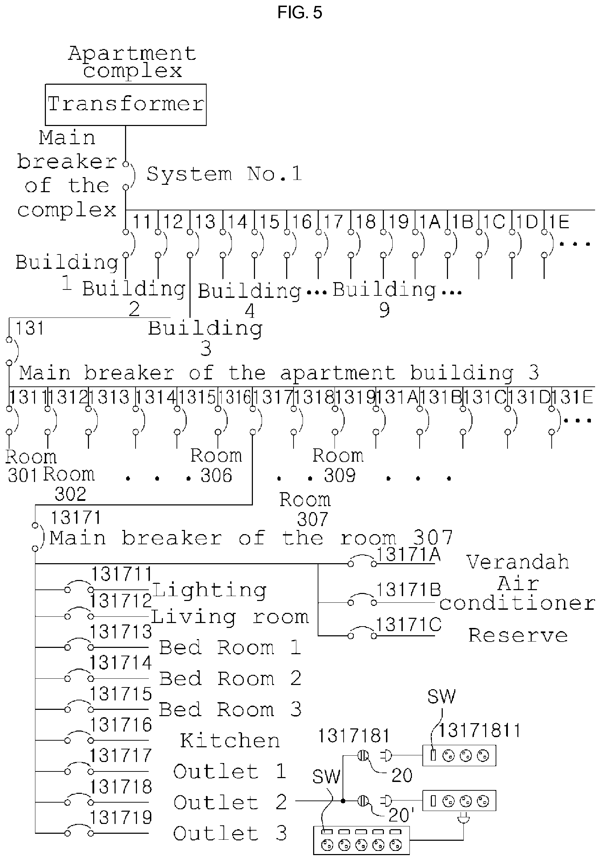

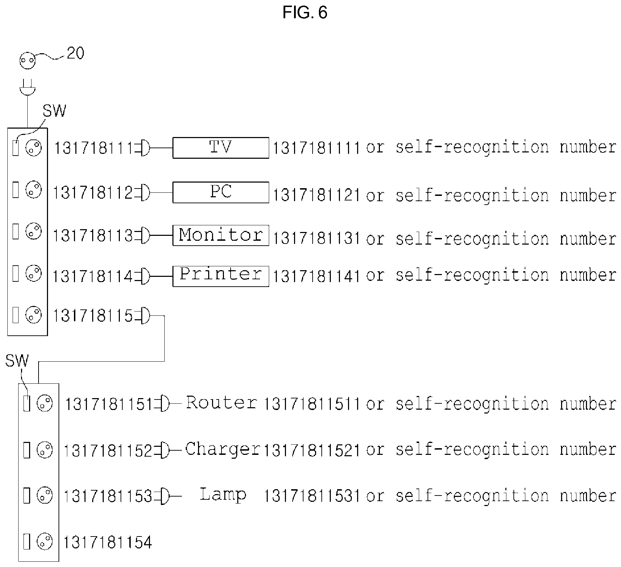

Hereinafter, a process for sorting degree of connections of electrical devices automatically by the control unit 40 of the electrical device management system according to the present disclosure will be described with reference to FIGS. 5 and 6.

FIG. 5 is a flow diagram illustrating a process for sorting a degree of connections of electrical devices automatically in an apartment complex according to the present disclosure.

In addition, in FIG. 5, though an apartment complex was described as an example for the sake of convenience, it is not limited to the apartment complex, and all electrical devices of a building, a factory, a large vessel, and so on can be applied.

In the following description, the recognition number will be described to increase a digit number thereof by one as an electric device goes down to be located at a lower stage in an electrical schematic diagram.

An electrical schematic diagram of the present embodiment is described as an example that an apartment complex is composed of nine apartment buildings and five shopping buildings 1A~1E as illustrated in FIG. 5.

In the apartment complex, as a power supply unit 100, for example, a 1000 kVA transformer is provided, and this transformer is equipped with, for example, a main breaker of the complex which is configured to have a composition of the breaker 10 as illustrated in FIG. 3. The main breaker of the complex has a recognition number 1 of a first degree of connections. In the main breaker of the complex having the recognition number 1, the control unit 40 according to the present disclosure is provided.

Breakers and switches of a main distribution board of the complex supply power to each of the apartment buildings and shopping buildings and are assigned recognition number 11, 12, ..., 1E of a second degree of connections, respectively, as shown in Table 1.

In FIG. 5, use of a multi tap of a room 307 of the apartment building 3 is described with reference to the electrical schematic diagram. In accordance with generation, sorting, and determination of the recognition number for the main breaker of the complex, a main breaker of the apartment building 3 is assigned to a recognition number 131 of a third degree of connections and a main breaker of the room 307 of the apartment building 3 is assigned to a recognition number 13171 of a fifth degree of connections. Like the recognition numbers 11~1E of distribution breakers of the apartment complex, recognition numbers 1311~131E of distribution breakers of the apartment building 3, and recognition numbers 131711~13171C of distribution breakers of the room 307 of the apartment building 3, recognition numbers are generated irrespective of orders of figures in the degree of connections.

[Table1]

| Transformer (1000 kVA) | | | | |
|---|---|---|---|---|
| Breaker, Switch of Main Distribution Board | | | | |
| System No. | Degree of Connections | Capacity (A) | Circuit Name | Installation, Management |
| 1 | First | 1200 | Main Breaker | |
| 11 | Second | 200 | Building 1 | Residential |
| 12 | Second | 200 | Building 2 | |
| 13 | Second | 200 | Building 3 | |
| 14 | Second | 200 | Building 4 | |
| 15 | Second | 200 | Building 5 | |
| 16 | Second | 200 | Building 6 | |
| 17 | Second | 200 | Building 7 | |
| 18 | Second | 200 | Building 8 | |
| 19 | Second | 150 | Building 9 | |
| 1A | Second | 150 | Building 10 | |
| 1B | Second | 150 | Building 11 | |
| 1C | Second | 150 | Building 12 | |
| 1D | Second | 150 | Security Light | Residential |
| 1E | Second | 150 | Waste Water Pump | Industrial |

The apartment buildings and shopping buildings of the second degree of connections in System No. column in Table 1 are written separately because charging systems thereof are different. That is, in the present disclosure, according to a setting in the control unit 40, electric charges can be automatically produced and managed by assigning different type of recognition number according to charging systems. Accordingly, management of electric charges can be efficiently implemented.

In addition, the apartment building 3 is divided into room 301, room 302, and so on and elevator 131B and so on. As shown in Table 2, four digit number of fourth degree of connections is assigned to each room. For example, the distribution breaker of the room 307 of the apartment building 3 is assigned to a recognition number 1317 of fourth degree of connections and the main breaker of the inside of the room 307 of the apartment building 3 is assigned to an five digit number of fifth degree of connections, therefore, the recognition of the main breaker of the room 307 of the apartment building 3 is 13171 of fifth degree of connections.

[Table2]

| 13 | Second | 200 A | Building 3 |
|---|---|---|---|
| Breaker, Switch of Building 3 Distribution Board | | | |
| System No. | Degree of Connections | Capacity (A) | Circuit Name |
| 131 | Third | 200 | Nain Breaker |
| 1311 | Fourth | 50 | Room 301 |
| 1312 | Fourth | 50 | Room 302 |
| 1313 | Fourth | 50 | Room 303 |

(continued)

| Breaker, Switch of Building 3 Distribution Board | | | |
|---|---|---|---|
| System No. | Degree of Connections | Capacity (A) | Circuit Name |
| 1314 | Fourth | 50 | Room 304 |
| 1315 | Fourth | 50 | Room 305 |
| 1316 | Fourth | 50 | Room 306 |
| 1317 | Fourth | 50 | Room 307 |
| 1318 | Fourth | 50 | Room 308 |
| 1319 | Fourth | 50 | Room 309 |
| 131A | Fourth | 50 | Room 310 |
| 131B | Fourth | 100 | Elevator |
| 131C | Fourth | 50 | Common |

Inside the room 307, for an air conditioner, an electrical device in a verandah, an electrical device for a reserve and so on which are connected directly to the main breaker, recognition number such as 13171A as six digit number of sixth degree of connections as shown in Table 3 is assigned. For each of breakers for lighting, a living room, and a flush mounted outlet and so on, six digit number of sixth degree of connections is assigned. In the case of an outlet 2, a recognition number 131718 of six digit number of sixth degree is assigned. For a flush mounted outlet 20 which is equipped with the electrical device management system, a recognition number is generated and the recognition number 1317181 of seventh degree of connections is assigned, and for an outlet or an electrical devices in lower stage connected to the outlet 20, a recognition number 13171811 of eighth degree of connections is assigned. However, for a conventional flush mounted outlet 20' which is not equipped with the electrical device management system, a recognition number is not generated. Consequentially, for an outlet or an electrical devices in lower stage connected to the outlet 20', a recognition number 1317181 of seventh degree of connections is assigned.

[Table3]

| 1317 | Fourth | 50 A | Room 307 | |
|---|---|---|---|---|
| Breaker of Room 307 Distribution Board | | | Installation, Management | |
| System No. | Degree of Connections | Capacity (A) | Circuit Name | |
| 13171 | Fifth | 50 | Main Breaker | |
| 131711 | Sixth | 30 | Lighting | Circuit Name, Password and so on may be changed by the user. |
| 131712 | Sixth | 20 | Living Room | |
| 131713 | Sixth | 20 | Bed Room 1 | |
| 131714 | Sixth | 20 | Bed Room 2 | |
| 131715 | Sixth | 20 | Bed Room 3 | |
| 131716 | Sixth | 20 | Kitchen | |
| 131717 | Sixth | 20 | Outlet 1 | |
| 131718 | Sixth | 30 | Outlet 2 | |
| 131719 | Sixth | 30 | Outlet 3 | |
| 13171A | Sixth | 30 | Verandah | |
| 13171B | Sixth | 30 | Air Conditioner | |
| 13171C | Sixth | 30 | Reserve | |

For a flush mounted outlet connected to an outlet 2 like this, for example, in the case of the outlet 20 according to the present disclosure as illustrated in FIG. 4, a recognition number 1317181 of seven digit number of seventh degree of connections is assigned as shown in Table 4.

[Table4]

| 131718 | Sixth | 30 A | Outlet 2 | |
|---|---|---|---|---|
| Outlet 2 of Flush Mounted Outlet | | | | (Existing Product) |
| System No. | Degree of Connections | Capacity (A) | Circuit Name | |
| 1317181 | Seventh | 15 | Multi Tap | 1 SW 3 Outlets |

In addition, for a multi tap connected to the outlet 20 and provided with switch (SW), as shown in Table 5, a recognition number 13171811 of eight digit number of eighth degree of connections.

[Table5]

| 1317181 | Seventh | 15 | Multi Tap | 1 SW 3 outlet |
|---|---|---|---|---|
| 5 SW 5 Outlet Multi Tap | | | | |
| System No. | Degree of Connections | Capacity (A) | Circuit Name | 5 SW 5 Outlet |
| 13171811 | Eighth | 6 | Multi Tap 5-1 | TV(Nineth-131718111) |
| 13171812 | Eighth | 6 | Multi Tap 5-2 | PC(Nineth-131718121) |
| 13171813 | Eighth | 6 | Multi Tap 5-3 | Monitor(Nineth-131718131) |
| 13171814 | Eighth | 6 | Multi Tap 5-4 | Printer(Nineth-131718141) |
| 13171815 | Eighth | 6 | Multi Tap 5-5 | 4 SW 4 Outlet Multi Tap |

Meanwhile, in the case a flush mounted outlet connected to the outlet 2 is the conventional outlet 20', a recognition number is not generated.

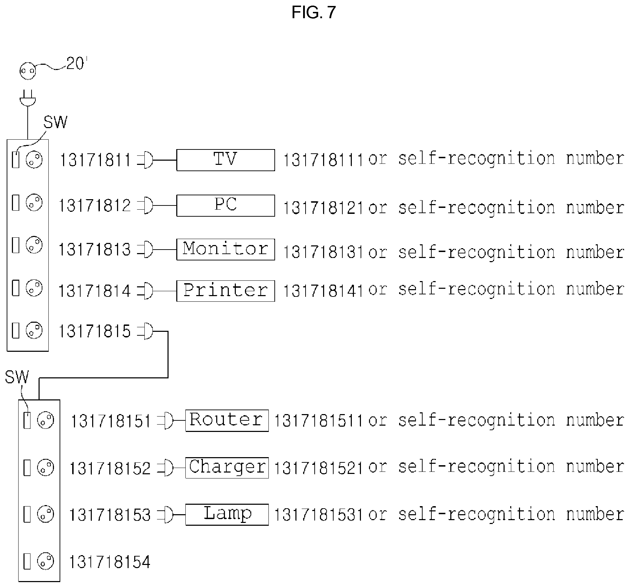

Next, for a case that a multi tap connected to a flush mounted outlet and provided with a SW for each outlet thereof, the multi tap with five outlets, for example, is described with reference to FIGS. 6 and 7.

FIG. 6 is a flow diagram illustrating a process for sorting a degree of connections of electrical devices automatically with respect to a multi tap connected to an outlet 20 according to the present disclosure illustrated in FIG. 5.

As illustrated in FIG. 6, for each outlet of the multi tap to which a recognition number 13171811 is assigned, as nine digit number of ninth degree of connections, as shown in Table 6, for example, a recognition number 131718111 is assigned to a first outlet. In addition, in the case that, for example, a TV is connected to the outlet having a recognition number 131718111, a recognition number 1317181111 of 10 digit number of 10th degree of connections or a serial number as a recognition number of the TV is assigned to the TV.

[Table 6]

| 13171815 | Eighth | 6 A | Multi Tap 5-5 | 4 SW 4 Outlet Multi Tap |
|---|---|---|---|---|
| 4 SW 4 Outlet Multi Tap | | | | |
| System No. | Degree of Connections | Capacity (A) | Circuit Name | 4 SW 4 Outlet |
| 131718151 | Ninth | 6 | Multi Tap 4-1 | Router (10th-1317181511) |
| 131718152 | Ninth | 6 | Multi Tap 4-2 | Charger (10th-1317181521) |
| 131718153 | Ninth | 6 | Multi Tap 4-3 | Lamp (10th-1317181531) |
| 131718154 | Ninth | 6 | Multi Tap 4-4 | |

In addition, in the case that a multi tap provided with four outlets and switches (SW) thereof is connected to a fifth outlet having a recognition number 131718115, as shown in Table 7, a recognition number 1317181151 of 10 digit numbers of 10th degree of connections is assigned to a first outlet of the multi tap provided with four outlets. In addition, in the case that, for example, a router is connected to the first outlet having a recognition number 1317181151, a recognition number 13171811511 of 11 digit number of 11th degree of Connections or a serial number as a recognition number of the router is assigned to the router.

[Table 7]

| 131718 | Sixth | 30 A | Outlet 2 | |
|---|---|---|---|---|
| 1317181 / Outlet 2 of Seventh Flush Mounted Outlet | | | | (Patented Product) |
| System No. | Degree of Connections | Capacity (A) | Circuit Name | |
| 13171811 | Eighth | 15 | Multi Tap | 1 SW 3 Outlet |

FIG. 7 is a flow diagram illustrating a process for sorting a degree of connections of electrical devices automatically with respect to a multi tap provided with switches and connected to a conventional outlet 20' illustrated in FIG. 5.

As described above, a recognition number is not assigned to the outlet 20'; however, in the case that a multi tap provided with a SW according to the present disclosure is applied to the outlet 20', a recognition number is assigned to this multi tap. That is, as illustrated in FIG. 7, for each of five outlets of a multi tap having no recognition number, as shown in Table 8, for example, a recognition number 13171811 of eight digit number of eighth degree of connections is assigned to a first outlet. In addition, in the case that, for example, a TV is connected to an outlet having a recognition number 13171811, a recognition number 131718111 of nine digit number of ninth degree of connections or a serial number as a recognition number of the TV is assigned to the TV.

[Table 8]

| 13171811 | Eighth | 15 | Multi Tap | 1 SW 3 Outlet |
|---|---|---|---|---|
| 5 SW 5 Outlet Multi Tap | | | | |
| System No. | Degree of Connections | Capacity (A) | Circuit Name | 5 SW 5 Outlet |
| 131718111 | Ninth | 6 | Multi Tap 5-1 | TV (10th-1317181111) |
| 131718112 | Ninth | 6 | Multi Tap 5-2 | PC (10th-1317181121) |
| 131718113 | Ninth | 6 | Multi Tap 5-3 | Monitor (10th-1317181131) |
| 131718114 | Ninth | 6 | Multi Tap 5-4 | Printer (10th-1317181141) |
| 131718115 | Ninth | 6 | Multi Tap 5-5 | 4 SW 4 Outlet Multi Tap |

In addition, in the case that a multi tap provided with four outlets and switches (SW) thereof is connected to a fifth outlet having a recognition number 13171815, a recognition number 131718151 of nine digit numbers of ninth degree of connections is assigned to a first outlet of the multi tap provided with four outlets. In addition, in the case that, for example, a router is connected to the first outlet having a recognition number 131718151, a recognition number 1317181511 of 10 digit number of 10th degree of connections or a serial number as a recognition number of the router is assigned to the router.

[Table 9]

| 131718115 | Ninth | 6 A | Multi Tap 5-5 | 4 SW 4 Outlet Multi Tap |
|---|---|---|---|---|
| 4 SW 4 Outlet Multi Tap | | | | |
| System No. | Degree of Connections | Capacity (A) | Circuit Name | 4 SW 4 Outlet |
| 1317181151 | 10th | 6 | Multi Tap 4-1 | Router (11th-1317181151 1) |
| 1317181152 | 10th | 6 | Multi Tap 4-2 | Charger (11th-13171811521) |
| 1317181153 | 10th | 6 | Multi Tap 4-3 | Lamp (11th-13171811531) |
| 1317181154 | 10th | 6 | Multi Tap 4-4 | |

Hereinafter a method of electrical device management according to the present disclosure for an electrical schematic diagram as described above will be described.

The recognition number generator 41 according to the present disclosure generates a recognition number for each electrical device as described above, and the sorting means 42 sorts a recognition number for each system as described above, and a sorted recognition number is stored in, for example, the storage unit 35.

In a state that the sorted recognition numbers are stored in the storage unit 35 according to an electrical schematic diagram as illustrated in FIGS. 5 to 7, a user or manager puts ON or OFF an electrical device, a circuit breaker, for example, having the highest degree of connections that is used and managed at the discretion of the user or the manager.

In the case that the determination means 43 recognizes, for example, 30 recognition numbers in a state that a circuit breaker as an electrical device having the highest degree of connections is ON and, for example, 10 recognition numbers in a state that the circuit breaker is OFF, then the number of electrical devices can be recognized as 20 which are disposed in a lower degree of connections under the circuit breaker having the highest degree of connections.

Therefore, according to the present disclosure as described above, when any one of electrical devices, even not having the highest degree of connections, is turned ON/OFF, the determination means 43 is able to recognize electrical devices in a lower degree of connections under that electrical device.

In addition, for the recognition number generated by the recognition number generator 41 in accordance with a determination of the determination means 43, the sorting means 42 is able to sort the degree of connections of electrical devices automatically by implementing ON/OFF of electrical devices in an initial period of electricity use or recognition of electrical devices. That is, since power as much as a variation in the use of electricity is transferred as is to electrical devices, outlet, transformer, and so on in the higher degree of connections of the same line, upper-lower degree of connections can be clearly classified.

In addition, since a variation of the power is reflected by a variation of not only a voltage and a current but also a change of a power factor, information on electrical devices can be easily determined by the determination means 43.

For example, in the case that power is not supplied to the main breaker of the room 307 of the apartment building 3, that is, in the case that the breaker having a recognition number 131 of higher degree of connections is OFF, recognition numbers of higher degree of connections and lower degree of connections with a recognition number 1317 as the center cannot be recognized.

In the case that the breaker having a recognition number 131 is ON, power is supplied to the main breaker having the recognition number 1317 of the room 307 of the apartment building 3, in FIG. 5. However, in the case that the breaker having a recognition number 1317 is OFF, although a user cannot recognize the upper and lower systems at the recognition number 131, the control unit 40 can recognize 141 upper systems and nine other systems, thus a total of 150 systems at the recognition number 1317.

In addition, in the case that the breaker having a recognition number 13171 of a room distribution board, provided in the room 307 of the apartment building 3, is OFF even though power is supplied since the breaker having recognition number 1317 is ON, the control unit 40 can recognize 150 upper systems and the recognition number 13171, thus a total of 151 systems at the recognition number 1317, and 151 upper systems at the recognition number 13171.

In the case that the breaker having a recognition number 13171 of a room distribution board in the room 307 is ON and each of 12 breakers in the room 307 in FIG. 5 is OFF, the control unit 40 can recognize 150 upper systems and the 13 lower systems, thus total 163 systems at the recognition number 1317, and 151 upper systems and the 12 lower systems, thus a total of 163 systems at the recognition number 13171.

In addition, in the case that the outlet 2 having a recognition number 131718 in FIG. 5 is ON, the control unit 40 can recognize 163 upper systems and the lower systems connected to the outlet 2.

Hereinafter a method of an automatic sorting of a degree of connections of Internet of Things and system recognition according to the electrical schematic diagram as described above will be described.

In the case that the power is not supplied from the power supply unit 100, even though, for example, a TV having a recognition number 131718111 is manipulated for ON/OFF operation as a user wants, through the Internet of Things, the control unit 40 does not work. That is, self-recognition number is not generated and other recognition numbers cannot also be recognized. Accordingly, power is not supplied to a load of distribution side even though the user manipulates ON/OFF operation through the Internet of Things.

In the case that the power is supplied from the power supply unit 100, the control unit 40 works irrespective of manipulation of ON/OFF operation, through the Internet of Things, of a TV having the recognition number 131718111, for example, as the user wants. Accordingly self-recognition number for the TV having the recognition number 131718111 is generated in the recognition number generator 41 and other recognition numbers of surroundings and the system are recognized and sorted in the sorting means 42, and then calculated and stored. Recognition numbers recognized at this time are at equal or higher degree of connections. In addition, although recognition numbers not directly related to a wiring system can be recognized, the recognized numbers of recognition numbers vary frequently depending on a sensitivity of wired and wireless communications. Accordingly, power can be supplied or blocked through Internet of Things to a load of distribution side for example by manipulating ON/OFF operation of the TV having the recognition number 131718111 as the user wants.

In addition, according to the present disclosure, a change of a variation in a voltage V and a voltage drop V, a current A and an earth fault current mA, a power factor %, a frequency Hz and so on of a power used in a lower degree breaker is simultaneously reflected into a breaker of a higher degree of connections by one and a breaker of higher degree of connections by two, upper and lower sides of a degree of connections can be clearly classified.

In addition, when a multi tap is installed to another outlet, the multi tap can also be determined by deleting an existing recognition number and regenerating a new recognition number at the outlet the multi tap is connected to.

Although the present disclosure accomplished by the present inventor has been described in detail according to an embodiment above, it is not limited to the above embodiment, and those skilled in the art will appreciate that various modifications, additions and substitutions are possible, without departing from the scope and spirit of the invention as disclosed in the accompanying claims.

Industrial Applicability

By using an electrical device management system according to the present disclosure, each electrical device in an electrical system is recognized and power consumption thereof can be controlled through Internet of Things. Furthermore, various electricity related safety accidents can be remarkably reduced by recognizing symptoms of accidents which may occur when electrical devices is controlled (ON/OFF) through the internet.

**Claims**

1. An electrical device management system, comprising:

   a power supply unit supplying and blocking power to a plurality of electrical or electronic devices;
   a recognition number generator generating recognition numbers of the plurality of electrical or electronic devices depending on the power supplied from the power supply unit;
   a sorting means sorting a degree of connections of the plurality of electrical or electronic devices in accordance with the recognition numbers generated by the recognition number generator; and
   a determination means determining information on the plurality of electrical or electronic devices in accordance with the degree of connections sorted by the sorting means.

2. The electrical device management system of claim 1, wherein the recognition number generator generates a manufacturer's unique number of an electrical or electronic device, an installation position number, a manager's management number, a user's password, and a recognition number of any one of transmission and distribution systems.

3. The electrical device management system of claim 1, wherein the determination means determines information on electrical or electronic devices by supplying or blocking the power to the electrical or electronic devices from the power supply unit.

4. The electrical device management system of claim 1, wherein the recognition number is assigned to each one of a breaker or a switch, a circuit breaker or an earth leakage breaker, a magnetic switch, or an outlet and a plug of an electrical system of generation and transformation, transmission and distribution, and a distribution board as well as an electrical device and a home appliance.

5. The electrical device management system of claim 1, wherein the determination means determines the number of the electrical or electronic devices, to which power is supplied from the power supply unit, by supplying or blocking power to the electrical or electronic devices from the power supply unit.

6. An electrical device, comprising:

   a power supply unit supplying and blocking power to the electrical or electronic devices;
   a recognition number generator generating recognition numbers of the electrical or electronic devices depending on the power supplied from the power supply unit;
   a sorting means sorting a degree of connections of the electrical or electronic devices in accordance with the recognition numbers generated by the recognition number generator; and
   a determination means determining information on the electrical or electronic devices in accordance with the degree of connections sorted by the sorting means, and
   controlling ON or OFF of the electrical or electronic devices in accordance with the recognition numbers.

FIG. 1

120

110

| Plug of the electrical device attached with the RFID tag |

Electrical outlet device

111

| Electric power measurement unit |

Power source

112

113

114

| RFID reader |  →  | Control unit |  →  | Communication unit |

EP 3 349 311 A1

FIG. 2

FIG. 3

FIG. 4

FIG. 5

FIG. 6

~20

SW

1317181111⊐D— | TV | 1317181111 or self-recognition number

1317181112⊐D— | PC | 1317181121 or self-recognition number

1317181113⊐D— | Monitor | 1317181131 or self-recognition number

1317181114⊐D— | Printer | 1317181141 or self-recognition number

1317181115⊐D—

SW

1317181151⊐D— Router 13171811511 or self-recognition number

1317181152⊐D— Charger 13171811521 or self-recognition number

1317181153⊐D— Lamp 13171811531 or self-recognition number

1317181154

FIG. 7

13171811 — TV — 131718111 or self-recognition number

13171812 — PC — 131718121 or self-recognition number

13171813 — Monitor — 131718131 or self-recognition number

13171814 — Printer — 131718141 or self-recognition number

13171815

131718151 — Router — 1317181511 or self-recognition number

131718152 — Charger — 1317181521 or self-recognition number

131718153 — Lamp — 1317181531 or self-recognition number

131718154

# EP 3 349 311 A1

<table>
<tr><td colspan="2" style="text-align:center">INTERNATIONAL SEARCH REPORT</td><td colspan="2">International application No.<br><br>**PCT/KR2016/010010**</td></tr>
</table>

| | |
|---|---|
| A. CLASSIFICATION OF SUBJECT MATTER | |

*H01R 24/76(2011.01)i, H01R 13/46(2006.01)i, H01R 13/66(2006.01)i, H01R 13/703(2006.01)i, H01R 103/00(2006.01)n*

According to International Patent Classification (IPC) or to both national classification and IPC

**B. FIELDS SEARCHED**

Minimum documentation searched (classification system followed by classification symbols)

H01R 24/76; H04W 74/08; H04L 29/02; H05B 37/02; H04L 12/12; H02J 13/00; G06Q 50/06; H01R 31/02; H01R 13/46; H01R 13/66; H01R 13/703; H01R 103/00

Documentation searched other than minimum documentation to the extent that such documents are included in the fields searched
Korean Utility models and applications for Utility models: IPC as above
Japanese Utility models and applications for Utility models: IPC as above

Electronic data base consulted during the international search (name of data base and, where practicable, search terms used)

eKOMPASS (KIPO internal) & Keywords: electric device, identification number, alignment, determination, address

**C. DOCUMENTS CONSIDERED TO BE RELEVANT**

| Category* | Citation of document, with indication, where appropriate, of the relevant passages | Relevant to claim No. |
|---|---|---|
| X | KR 10-2014-0098570 A (LG ELECTRONICS INC.) 08 August 2014<br>See paragraphs [0025]-[0030], claims 1-10 and figures 1-4. | 1-6 |
| A | KR 10-2011-0113200 A (ZTE CORPORATION) 14 October 2011<br>See paragraphs [0019]-[0025], claim 1 and figures 1-5. | 1-6 |
| A | KR 10-2012-0097105 A (SAMSUNG ELECTRONICS CO., LTD.) 03 September 2012<br>See paragraphs [0051]-[0065], claim 1 and figures 1-6. | 1-6 |
| A | KR 10-2012-0086979 A (SAMSUNG ELECTRONICS CO., LTD.) 06 August 2012<br>See paragraphs [0028]-[0045], claim 1 and figures 1-5. | 1-6 |
| A | JP 2015-510745 A (HSIEH, Homing) 09 April 2015<br>See paragraphs [0024]-[0036], claims 1-4 and figures 1-4. | 1-6 |

| | |
|---|---|
| ☐ Further documents are listed in the continuation of Box C. | ☒ See patent family annex. |

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 29 DECEMBER 2016 (29.12.2016) | **30 DECEMBER 2016 (30.12.2016)** |

| Name and mailing address of the ISA/KR | Authorized officer |
|---|---|
| Korean Intellectual Property Office<br>Government Complex-Daejeon, 189 Seonsa-ro, Daejeon 302-701, Republic of Korea<br>Facsimile No. 82-42-472-7140 | Telephone No. |

Form PCT/ISA/210 (second sheet) (January 2015)

| Patent document cited in search report | Publication date | Patent family member | Publication date |
|---|---|---|---|
| KR 10-2014-0098570 A | 08/08/2014 | NONE | |
| KR 10-2011-0113200 A | 14/10/2011 | CN 101841889 A | 22/09/2010 |
| | | CN 101841889 B | 05/11/2014 |
| | | EP 2410801 A1 | 25/01/2012 |
| | | EP 2410801 B1 | 28/08/2013 |
| | | JP 2012-518297 A | 09/08/2012 |
| | | KR 10-1267448 B1 | 31/05/2013 |
| | | US 2011-0299415 A1 | 08/12/2011 |
| | | US 8649288 B2 | 11/02/2014 |
| | | WO 2010-105518 A1 | 23/09/2010 |
| KR 10-2012-0097105 A | 03/09/2012 | US 2012-0219007 A1 | 30/08/2012 |
| | | US 9450777 B2 | 20/09/2016 |
| KR 10-2012-0086979 A | 06/08/2012 | CN 102621900 A | 01/08/2012 |
| | | EP 2523006 A2 | 14/11/2012 |
| | | US 2012-0197451 A1 | 02/08/2012 |
| | | US 9236741 B2 | 12/01/2016 |
| JP 2015-510745 A | 09/04/2015 | CN 103187803 A | 03/07/2013 |
| | | EP 2800238 A1 | 05/11/2014 |
| | | EP 2800238 A4 | 16/09/2015 |
| | | US 2014-0327310 A1 | 06/11/2014 |
| | | WO 2013-097572 A1 | 04/07/2013 |

INTERNATIONAL SEARCH REPORT
Information on patent family members

International application No.

**PCT/KR2016/010010**

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 20120097105

- KR 20130071165